# FASCICULE DE BREVET EUROPEEN

(11) **EP 0 864 886 B1**
(45) Date de publication et mention de la délivrance du brevet: **27.06.2007**
(21) Numéro de dépôt: 98400544.7
(22) Date de dépôt: 09.03.1998
(51) Int. Cl.: G02B 6/12, H01S 3/08, G02B 6/26

(54) **Procédé de fabrication de circuits optiques intégrés permettant de minimiser les pertes optiques de couplage**
Herstellungsverfahren von integrierten optischen Schaltungen zur Minimierung der optischen Kopplungsverluste
Fabrication process of integrated optical circuits to minimise optical coupling losses

(30) Priorité: 13.03.1997 FR 9702993
(43) Date de publication de la demande: 16.09.1998
(73) Titulaire: Avanex Corporation, Fremont, CA 94538 (US)
(72) Inventeur: Leclerc, Denis, 91430 Igny (FR); Mestric, Roland, 75007 Paris (FR)
(74) Mandataire: Feray, Valérie

(56) Documents cités:
- EP-A- 0 642 041
- EP-A- 0 665 450
- WO-A-96/09668
- US-A- 5 402 511

## Description

La présente invention se rapporte à un procédé de fabrication de circuits optiques intégrés comprenant des guides d'onde ayant des structures différentes, notamment leurs structures verticale et latérale. Ce procédé permet notamment d'améliorer le couplage entre les différents guides et, par conséquent, de minimiser les pertes optiques.

Les circuits optiques intégrés sont conçus pour renfermer plusieurs composants optiques ayant des structures et des fonctions différentes. Ces circuits sont réalisés en deux temps. Dans un premier temps, les différents composants actifs et/ou passifs sont intégrés sur un substrat selon une méthode dite de couplage bout à bout, encore dénommée "butt coupling" en terminologie anglo-saxonne. Puis, dans un deuxième temps, les guides d'onde des différents composants sont gravés sous forme de rubans, de manière à ce qu'ils puissent assurer le confinement latéral de la lumière.

WO 96/09668 concerne un dispositif semiconducteur comprenant un guide d'onde de largeur variable. Le largeur du guide à une décroissance progressive vers l'entrée et le sortie de la lumière.

EP 0 642 041 décrit un composante optique semiconducteur à ruban. Le composante compris une structure guidante est une structure de commande fabriquée au dessus de la structure guidante.

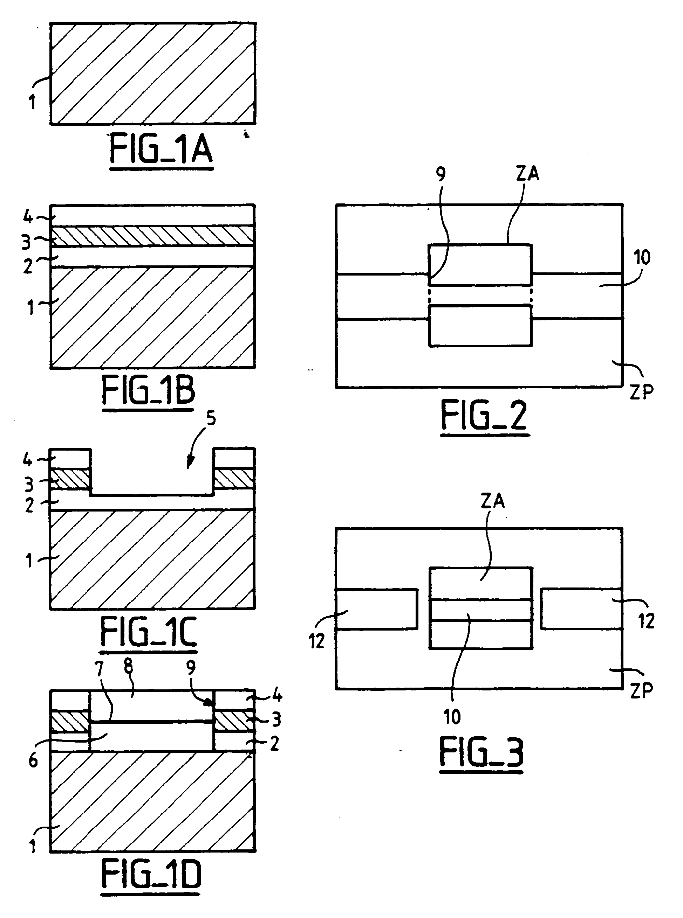

La méthode de "butt coupling", permettant d'intégrer les composants optiques, est très courante aujourd'hui. Les schémas des figures 1A à 1D représentent des vues en coupe longitudinale d'un circuit optique intégré au cours des différentes étapes de cette méthode de "butt coupling".

Cette méthode consiste, dans un premier temps, à faire croître sur un substrat 1 différentes couches 2, 3, 4 destinées à former une structure passive par exemple. Cet empilement de couches est par exemple constitué par une première couche de phosphure d'indium (InP) 2, une deuxième couche de matériau quaternaire 3 apte à jouer le rôle de guide d'onde, et enfin une troisième couche d'InP 4.

Au moins une cavité 5 est ensuite pratiquée dans cet empilement de couches, selon un procédé de gravure classique et optimisé. Cette cavité 5 est réservée à l'intégration d'un autre type de composant optique, comme par exemple un laser à semi-conducteur.

Ce composant actif est réalisé en faisant croître, par épitaxie, plusieurs couches 6, 7 et 8. La couche 7 constitue le guide d'onde et est par exemple formée d'un matériau quaternaire tandis que les autres couches 6 et 8 sont par exemple formées d'InP. La structure de ce guide d'onde 7 est différente de celle du guide passif 3. L'interface 9 entre les deux types de composants est dénommée "butt joint" en terminologie anglo-saxonne.

A ce stade de la fabrication des circuits optiques intégrés, les différents guides optiques doivent être gravés sous forme de rubans de manière à ce qu'ils puissent assurer le confinement latéral de la lumière. Depuis les cinq dernières années, de nombreuses tentatives ont été réalisées pour graver les guides d'onde selon une méthode dite d'auto-alignement.

Cette méthode consiste à définir les structures latérales des guides en une seule étape, à l'aide d'un seul masque 10 tel qu'illustré par le schéma d'une vue de dessus d'un circuit à la figure 2. La région référencée ZA correspond à la zone active tandis que la région référencée ZP correspond à la zone passive.

Cependant, cette méthode d'auto-alignement nécessite de faire un compromis sur le procédé de réalisation des rubans des guides d'onde. Un tel compromis n'est pas sans conséquences sur les performances du dispositif final.

En effet, les différents composants optiques actifs et passifs sont, de manière classique, fabriqués séparément et les structures de ces guides d'onde sont définis selon des technologies complètement différentes et optimisées. Or, lorsque l'on place deux structures différentes bout à bout et que l'on réalise la gravure de leur guides d'onde au moyen d'un masque 10 unique, en général une seule technologie est utilisée, et non plus deux.

La composition du masque 10 utilisé en auto-alignement est généralement différente de celle des masques utilisés dans les procédés classiques de fabrication de chacun des composants optiques pris isolément. En effet, cette composition peut être de préférence métallique au lieu d'être en résine ou en silice. Cette différence de composition entraîne une modification de la technologie de gravure mise en oeuvre pour définir les structures des guides d'onde. De ce fait, la méthode d'auto-alignement nécessite de faire un compromis sur la technologie de gravure pour définir simultanément toutes les structures de guides d'onde.

Les tentatives réalisées jusqu'à présent pour obtenir un compromis satisfaisant n'ont pas abouti et dans tous les cas, elle ne permettent pas d'envisager une fabrication de circuits optiques intégrés en grande masse.

Un premier problème à résoudre consiste donc à trouver une autre solution pour réaliser des circuits optiques intégrés au moyen de technologies de fabrication couramment utilisées et optimisées pour chacun des éléments qui constituent ces circuits.

La demanderesse a pour cela envisagé d'intégrer les différents composants optiques par la méthode de "butt coupling" puis de définir les structures latérales des guides d'onde par une méthode dite de réalignement. Cette méthode de réalignement consiste plus particulièrement à définir les guides d'onde, ayant des structures différentes, à partir de plusieurs masques éventuellement de composition différente et permettant la mise en oeuvre des technologies couramment utilisées et optimisées pour chaque type de structure.

La figure 3 schématise une vue de dessus d'un circuit optique intégré comprenant une zone active ZA et une zone passive ZP sur lequel sont disposés deux types de masque 10 et 12 respectivement utilisés pour la réalisation d'un ruban de guide d'onde actif et pour la réalisation de deux rubans de guides d'onde passifs.

La méthode de réalignement consiste en fait à protéger d'une part une partie de la zone active ZA, au moyen d'un masque 10, et d'autre part toute la zone passive ZP, puis à graver le guide optique de la structure active selon la technologie de gravure adaptée et optimisée couramment utilisée. Dans un deuxième temps, une partie de la zone passive ZP est protégée au moyen d'un ou de plusieurs autre(s) masque(s) 12, et toute la zone active ZA est protégée par de la résine par exemple, puis le guide optique de la structure passive est gravé selon la technologie de gravure adaptée et optimisée couramment mise en oeuvre.

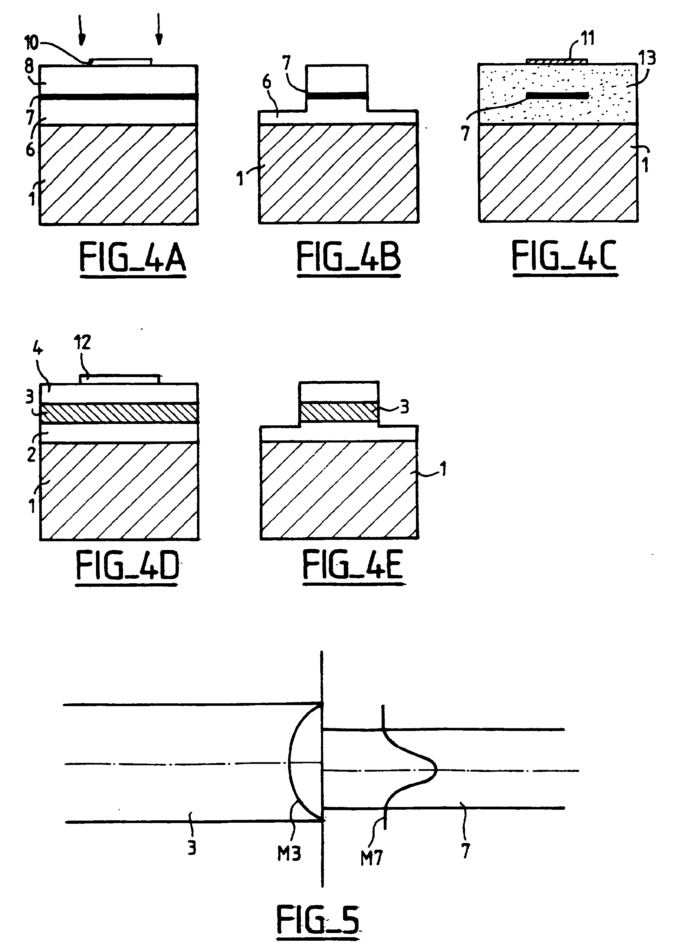

L'exemple schématisé sur les figures 4A à 4E permet de mieux comprendre la manière dont les différents guides d'onde sont définis. Dans un premier temps, une structure active et deux structures passives, situées de part et d'autre de la structure active, ont été intégrées sur un substrat 1 selon la méthode de "butt coupling" telle qu'expliquée précédemment en référence aux figures 1A à 1D. Les schémas des figures 4A à 4C correspondent à une vue d'une coupe transversale du circuit intégré réalisée au travers de la structure active. Les schémas des figures 4D et 4E, quant à eux, correspondent à une vue d'une coupe transversale du circuit intégré réalisée au travers de la structure passive.

La méthode de réalignement consiste, dans un premier temps, à protéger d'une part toute la zone passive et d'autre part une partie de la structure active par un masque 10 puis à graver les couches 6, 7, 8 situées de part et d'autre de ce masque 10. Le ruban de couche active ainsi obtenu, tel qu'illustré sur la figure 4B, est ensuite enterré dans une couche de gaine 13.

Des étapes d'implantation protonique sont ensuite effectuées dans la couche de gaine 13 pour augmenter la résistivité du matériau et, par conséquent, pour augmenter le confinement du courant dans la couche active. Une électrode est par ailleurs réalisée par dépôt de métallisation 11 au dessus du ruban de couche active 7 pour permettre d'effectuer des injections de courant dans la structure active.

Dans un deuxième temps, un masque 12 est positionné au dessus de la structure passive, de manière à réaliser la gravure des guides passifs (figure 4D).

De la résine est au préalable appliquée sur l'ensemble des deux structures active et passive de manière à protéger la structure active d'une part et à permettre le positionnement des masques 12 sur la structure passive d'autre part. Les masques 12 sont par exemple constitués par une plaque de quartz sur laquelle sont dessinées des empreintes correspondantes aux guides passifs à réaliser. Les masques 12 sont apposés sur le circuit intégré puis leur position est ajustée de manière à aligner les empreintes dessinées avec le guide d'onde du composant actif. Cet ajustement est imprécis car il se fait à l'oeil. Lorsque les masques 12 sont bien ajustés, la résine est insolée, et l'empreinte des guides est reportée sur la résine. Les rubans de guide passif sont alors gravés selon la forme de l'empreinte puis la résine est retirée au moyen d'un solvant. Contrairement au ruban de couche active 7, les guides d'onde de structure passive 3 ne sont pas enterrés.

La procédure de réalignement qui vient d'être décrite est classique et bien connue de l'homme du métier.

Cette méthode de réalignement est très avantageuse car elle respecte les procédés classiques qui sont optimisés et adaptés à la fabrication de chaque type de structure. Cependant, elle pose par ailleurs de grosses difficultés quant à l'alignement des différents guides d'onde. En effet, il est très difficile de positionner correctement les masques destinés à définir les différents guides puisque ce positionnement ne peut se faire qu'au microscope, c'est à dire à l'oeil. De ce fait, un alignement de deux guides d'onde de structures différentes à moins de 1µm (10⁻⁶ m) d'erreur est très difficile à obtenir.

La figure 5 schématise une vue de dessus de deux guides de structures différentes, alignés selon la méthode de réalignement. Le guide référencé 3 est par exemple un guide de structure passive et le guide référencé 7 est un guide de structure active. Les deux guides d'onde 7 et 3 sont légèrement mais suffisamment désalignés pour engendrer de grandes pertes optiques de couplage, dues à un mauvais recouvrement des différents modes optiques M3, M7 des ondes issues des guides.

La présente invention permet de résoudre ce deuxième problème puisqu'elle propose un procédé de fabrication de circuits optiques intégrés dans lesquels des pertes optiques de couplage sont très amoindries.

L'invention se rapporte plus particulièrement à un procédé de fabrication tel que décrit dans la revendication 1.

Selon une autre caractéristique de l'invention, lesdits masques ont des extrémités correspondant aux portions d'extrémité couplées desdits guides qui sont élargies.

Selon une autre caractéristique de l'invention, lesdites portions d'extrémité sont élargies sous forme de cônes dont les génératrices sont rectilignes ou incurvées.

Un autre objet de l'invention concerne un circuit optique intégré tel que défini dans la revendication 4.

Selon une autre caractéristique de l'invention, lesdites portions d'extrémité couplées se présentent sous la forme de cônes dont les génératrices sont rectilignes ou incurvées.

Selon une autre caractéristique de l'invention, le circuit optique intégré comprend une zone active, renfermant un guide d'onde de structure active enterré dans une couche de gaine, et une zone passive divisée en deux parties, une première partie étant enterrée dans la couche de gaine et renfermant la (les) portion(s) d'extrémité couplée(s) de forme conique du guide de structure active, et une deuxième partie étant non enterrée et comportant un guide d'onde de structure passive et sa (ses) portion(s) d'extrémité couplée(s) de forme conique.

Selon une autre caractéristique de l'invention, le circuit optique intégré comprend une zone active, renfermant un, guide d'onde de structure active et sa (ses) portion(s) d'extrémité couplée(s) de forme conique enterrés dans une couche de gaine, et une zone passive non enterrée comportant un guide d'onde de structure passive et sa (ses) portion(s) d'extrémité couplée(s) de forme conique.

D'autres particularités et avantages de l'invention apparaîtront à la lecture de la description faite à titre d'exemple illustratif et non limitatif, en référence aux figures annexées qui représentent :
- les figures 1A à 1D, déjà décrites, des schémas de vues en coupe longitudinale d'un circuit optique intégré au cours des étapes de fabrication selon la méthode de "butt coupling",
- La figure 2, déjà décrite, un schéma d'une vue de dessus d'un circuit optique intégré muni d'un masque unique utilisé pour définir les différents guides d'onde selon la méthode d'auto-alignement,
- la figure 3, déjà décrite, un schéma d'une vue de dessus d'un circuit optique intégré muni de deux types de masques utilisés pour définir deux guides d'onde de structure différente selon la méthode de réalignement,
- les figures 4A à 4E, des schémas de vues en coupe transversale d'un circuit optique intégré au cours des étapes destinées à définir différentes structures de guides d'onde selon la méthode de réalignement,
- la figure 5, déjà décrite, un schéma d'une vue de dessus de deux types de guides d'onde réalisés et alignés selon la méthode de réalignement,
- la figure 6A, un schéma d'une vue de dessus d'un circuit optique intégré selon l'invention muni de deux types de masques utilisés pour définir deux guides d'onde de structures différentes,
- la figure 6B, une vue en coupe transversale selon A-A du circuit de la figure 6A,
- la figure 6C une vue en coupe transversale selon B-B du circuit de la figure 6A,
- la figure 7A, une vue de dessus de deux guides d'onde de structures différentes dans un circuit optique intégré selon l'invention,
- la figure 7B, une vue en coupe transversale de trois parties différentes du circuit de la figure 7A,
- la figure 8, une vue en perspective du circuit de la figure 7A,
- la figure 9, une vue en perspective d'un circuit optique intégré selon une variante de réalisation,
- la figure 10, un schéma de courbes présentant le taux de recouvrement des modes optiques de deux guides d'onde de structures différentes en fonction du désalignement de ces guides et de la taille latérale de mode des ondes issues de ces guides.

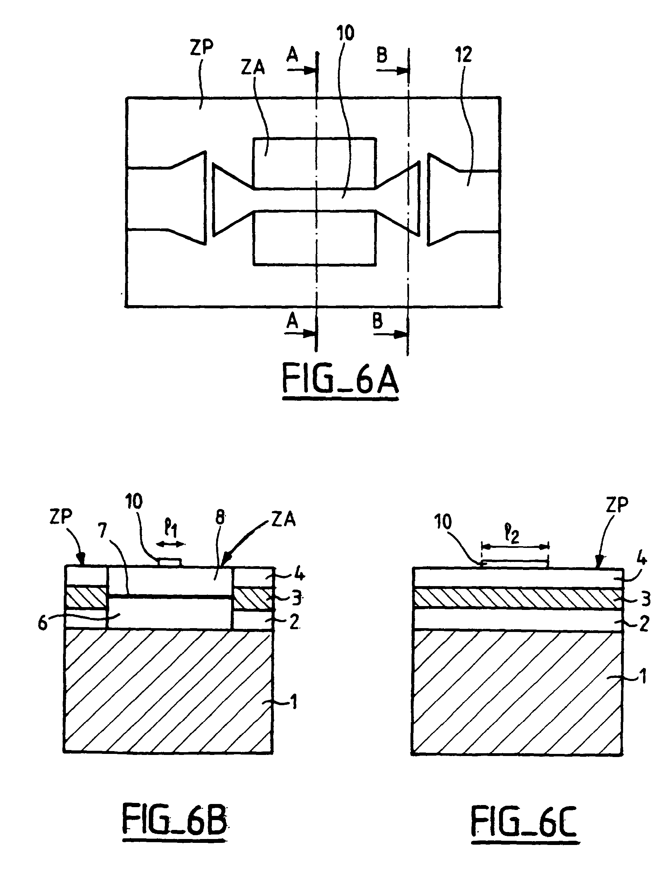

Les figures 6A, 6B et 6C représentent respectivement une vue de dessus d'un circuit optique intégré selon l'invention muni de masques destinés à définir la forme de deux types de guides d'onde, et des vues en coupe transversales selon A-A et B-B du masque 10 destiné à définir le guide actif. Dans cet exemple le circuit optique comprend un composant actif de type laser à semi-conducteur, et deux composants passifs situés de part et d'autre du composant actif.

Bien sûr, l'invention ne se limite pas à cet exemple et une multitude de circuits optiques intégrés comprenant plusieurs types de composants actifs et/ou passifs peuvent être réalisés selon le même procédé. Ainsi, l'invention peut également s'appliquer à l'intégration de deux composants actifs, tels qu'un laser et un modulateur par exemple, ayant chacun une structure enterrée ou non.

Sur le schéma de la figure 6A, la région référencée ZA correspond à la zone active tandis que la région référencée ZP correspond à la zone passive. Deux types de masques 10 et 12 sont utilisés pour définir respectivement le guide d'onde du composant actif et le guide d'onde du composant passif.

De manière avantageuse, les masques utilisés pour réaliser les différents guides d'onde ne possèdent pas une largeur constante. En effet, pour pouvoir minimiser les pertes optiques de couplage, les extrémités des différents guides destinées à être couplées sont conçues de manière à élargir la taille de mode des ondes optiques sortant de ces extrémités.

Pour cela, les extrémités des masques définissant chaque guide optique, qui correspondent à des extrémités couplées de ces guides, sont dessinées sous forme de cônes. Les génératrices de ces cônes peuvent être rectilignes ou bien légèrement incurvées.

Dans l'exemple représenté sur la figure 6A, le composant actif est couplé, à chacune de ses extrémités, avec un composant passif. En conséquence, les deux extrémités du masque 10 sont dessinées en forme de cône. Par ailleurs, le masque 10 utilisé pour définir le guide d'onde actif se prolonge de part et d'autre de la zone active ZA.

Cependant, il est tout à fait possible, dans une variante de réalisation, d'utiliser un masque aux dimensions de la zone active ZA. De plus, dans le cas où le composant actif n'est couplé qu'à un seul autre composant, une seule extrémité, correspondant à l'extrémité couplée, sera dessinée sous la forme d'un cône et se prolongera éventuellement dans la zone passive.

La figure 6B schématise une vue en coupe transversale selon A-A du circuit de la figure 6A muni du masque 10. Dans cette zone, le circuit comporte un empilement de couches 6, 7, 8 correspondant à la zone active ZA et un empilement de couches 2, 3, 4 correspondant à la zone passive ZP. La couche 7 représente la couche active et est par exemple réalisée dans un matériau quaternaire. Le masque 10 présente alors une largeur 11 correspondant à la largeur que la guide d'onde 7 doit présenter pour assurer un bon confinement latéral de la lumière.

La figure 6C schématise une vue en coupe transversale selon B-B du circuit de la figure 6A muni du masque 10. Dans cette zone, le circuit comporte un empilement de couches 2, 3, 4 correspondant à la zone passive ZP. La couche 3 représente un guide d'onde passif. Le masque 10 présente, dans cette région, une largeur 12 supérieure à la largeur 11 de ce même masque situé au dessus de la zone active ZA. Cette largeur 12 augmente de manière continue en s'éloignant de la zone active. L'extrémité conique du guide permet ainsi d'élargir la taille de mode de l'onde optique sortant du guide d'onde actif 7.

Le procédé selon l'invention permettant de définir les guides d'onde des différents composants actifs et passifs consiste dans un premier temps à protéger une partie de la zone active ZA et une partie de la zone passive ZP par le masque 10 aux extrémités coniques puis à graver les couches 6, 7, 8 et 2, 3, 4 situées de part et d'autre de ce masque 10. Le guide actif aux extrémités coniques ainsi obtenu est ensuite enterré dans une couche de gaine.

Dans un deuxième temps, la zone active est recouverte d'une couche de protection et les masques 12 à une extrémité conique sont positionnés au dessus de la structure passive, de manière à réaliser la gravure des guides passifs.

De la résine est au préalable appliquée sur l'ensemble des deux structures active et passive de manière à protéger la structure active d'une part et à permettre le positionnement des masques 12 sur la structure passive d'autre part. Les masques 12 sont par exemple constitués par une plaque de quartz sur laquelle sont dessinées des empreintes correspondantes aux guides passifs à réaliser. Les masques 12 sont apposés sur le circuit intégré puis leur position est ajustée de manière à aligner les empreintes dessinées avec le guide d'onde du composant actif. Lorsque les masques 12 sont bien ajustés, la résine est insolée, et l'empreinte des guides est reportée sur la résine. Les rubans de guide passif sont alors gravés selon la forme de l'empreinte puis la résine est retirée au moyen d'un solvant. Contrairement au ruban de couche active 7, les guides d'onde de structure passive 3 ne sont pas enterrés.

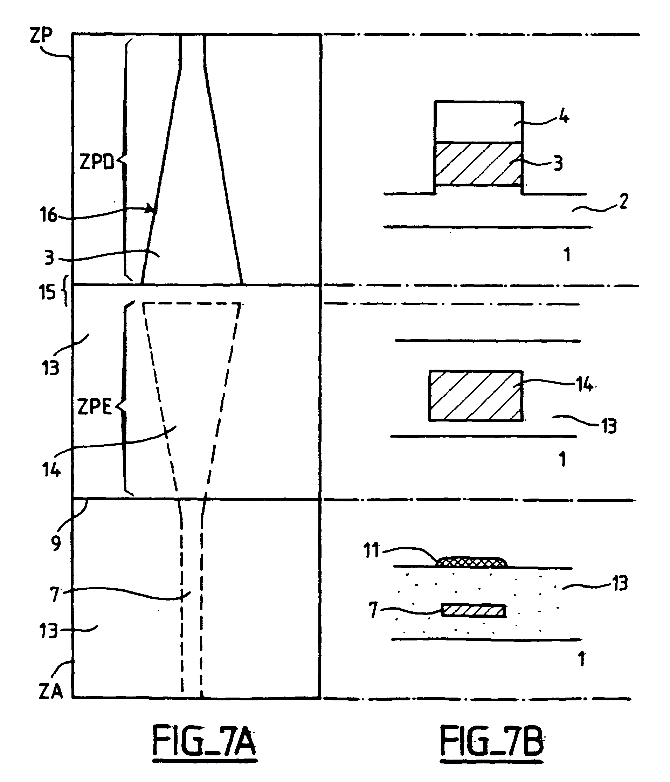

Les figures 7A et 7B représentent respectivement une vue de dessus d'un circuit optique intégré selon l'invention et des vues en coupe transversale de trois parties distinctes de ce circuit. La vue de dessus de la figure 7A illustre la forme de chaque guide d'onde. Le circuit optique intégré comporte deux zones ZA et ZP correspondant respectivement à la zone active et à la zone passive. Dans l'exemple de la figure 7A, la zone passive ZP est elle-même divisée en deux parties ZPE et ZPD qui sont décrites plus en détails dans ce qui suit.

Les traits pointillés situés dans la zone active ZA représentent la trace du guide d'onde 7 du composant actif. Ce guide d'onde est gravé sous la forme d'un ruban et enterré dans une couche de gaine 13. Sa largeur est par exemple égale à 1,2µm. Ce guide d'onde 7 est également représenté sur la vue en coupe transversale de la figure 7B en regard. Son épaisseur est par exemple égale 0,4µm. De préférence, cette couche active 7 est réalisée dans un matériau quaternaire possédant une largeur de bande interdite proche de la longueur d'onde d'utilisation de 1,55µm, c'est à dire égale, en longueur d'onde, à 1,5µm. La couche de gaine 13 est quant à elle réalisée dans un matériau d'InP. Ce matériau est de surcroît dopé en porteurs de type p afin d'améliorer le confinement de la lumière dans la couche active 7. La référence 1 désigne le substrat sur lequel le circuit est réalisé. La référence 11 désigne une métallisation appliquée au dessus du ruban de couche active 7 et jouant le rôle d'une électrode apte à injecter du courant dans la structure active.

Le passage entre la zone active ZA et la zone passive ZP est situé à l'interface 9 dénommée "butt joint" en terminologie anglo-saxonne.

De manière avantageuse, la zone passive ZP comporte deux parties distinctes, l'une ZPE étant enterrée dans la couche de gaine 13 et l'autre ZPD n'étant pas enterrée. La zone non enterrée ZPD correspond au guide de structure passive 3 et la zone enterrée ZPE correspond à l'extrémité conique du guide d'onde de structure active 7.

Pour cela le masque utilisé pour définir le ruban de couche active 7 se prolonge au delà de la zone active ZA et recouvre donc une partie de la zone passive ZP. Cette partie ZPE de zone passive est par conséquent gravée puis enterrée de la même manière que la couche active 7, comme il a été expliqué précédemment en référence aux figure 6A à 6C.

De préférence cette partie ZPE de zone passive correspond à l'extrémité conique du guide actif. En conséquence, les traits pointillés représentés dans cette zone ZPE correspondent à la trace de l'extrémité conique 14, du guide optique 7, qui est enterrée dans une couche de gaine.

Cette partie conique permet d'élargir la taille de mode de l'onde optique issue du guide optique 7. Elle est par exemple réalisée sur une longueur de 200µm et présente une largeur maximum de quelques microns, par exemple 5µm.

Une vue en coupe transversale de cette zone ZPE est schématisée sur la figure 7B en regard. Le guide d'onde 14 possède par exemple une épaisseur de 1µm. Il est avantageusement réalisé dans un matériau quaternaire ayant une largeur de bande interdite égale, en longueur d'onde, à 1,1µm et est enterré dans la couche de gaine 13 d'InP. Dans cette partie, la couche de gaine n'est pas nécessairement dopée en porteurs de type p.

La deuxième partie ZPD de la zone passive ZP n'étant pas enterrée, le guide d'onde 3 est représenté en traits pleins. La largeur de ce guide est légèrement supérieure à celle du guide 7 de structure active. Elle est par exemple égale à 2,5µm. De manière avantageuse, l'extrémité de ce guide 3, couplée à celle du guide actif 7, est également gravée sous la forme d'un cône 16 de manière à élargir la taille de mode de l'onde issue de ce guide. La longueur de ce cône 16 peut par exemple être égale à 200µm et sa largeur maximum est de quelques micron, elle peut par exemple atteindre 6µm.

La vue en coupe transversale de cette partie ZPD est schématisée sur la figure 7B en regard. Cette zone se compose en fait d'un empilement de plusieurs couches 2, 3 et 4 épitaxiées sur un substrat 1. Le guide passif 3 présente la même épaisseur que dans la zone passive enterrée ZPE. Les couches inférieures 2 et supérieures 4 sont de préférence réalisées dans du phosphure d'indium et ont également une épaisseur de 1µm.

Le substrat 1 sur lequel le circuit est réalisé présente par exemple une épaisseur de 300µm.

Selon un aspect particulier de l'invention, les extrémités coniques 14 et 16 des deux types de guide d'onde 3 et 7 sont séparées l'une de l'autre par une certaine distance. Cette séparation 15 correspond à une zone non guidée latéralement qu'on peut appeler zone de guide planaire ou zone neutre. Dans cette zone, l'onde optique reste par contre guidée verticalement.

La présence de cette zone 15 est essentiellement due à la technologie de fabrication. En effet, au cours du procédé de fabrication, les différents masques ne sont pas mis bout à bout mais ils sont volontairement écartés afin de garantir l'absence de recouvrement des procédés de gravure des différents guides. Un tel recouvrement entraînerait de très fortes dégradations dans les fonctions optiques des guides, voire même une complète destruction.

En pratique, la longueur de la zone 15 résulte d'un écartement imposé entre les masques qui définissent les deux guides à coupler et la valeur de cet écartement sera choisie supérieure à la tolérance sur le positionnement des masques pour les procédés utilisés. On prendra typiquement une valeur d'environ 4 à 5µm. La largeur de la zone 15 sera choisie suffisante pour assurer l'absence de guidage latéral du mode dans cette zone.

On peut noter que cette zone serait très gênante si la taille des guides d'onde n'était pas élargie car les pertes optiques qu'elle engendre seraient très importantes par rapport au taux de recouvrement des modes optiques des différents guides. Selon l'invention, le fait d'élargir la taille des guides permet donc de minimiser les inconvénients de cette zone 15 en autorisant une tolérance accrue sur l'écartement entre les masques sans augmenter les pertes optiques.

D'autre part, le fait que cette zone 15 non guidée latéralement ne soit pas confondue avec l'interface 9 située entre la zone active ZA et la zone passive ZP permet d'améliorer la transition entre ces deux types de zones ZA et ZP.

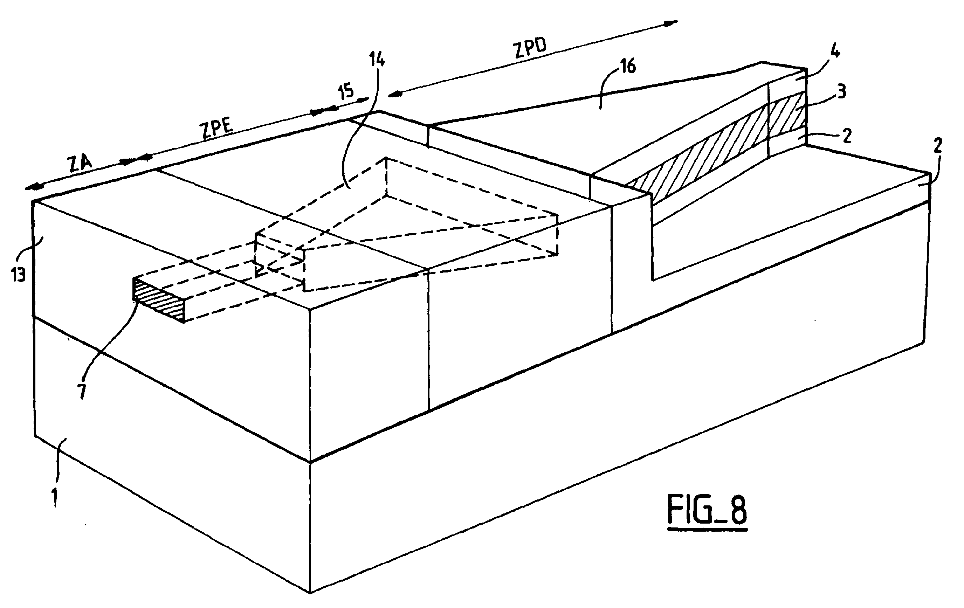

La figure 8 représente un schéma en perspective du circuit qui vient d'être décrit. Les mêmes références que dans les figures 7A et 7B sont utilisées pour désigner les mêmes éléments.

Dans une variante de réalisation, il est en outre possible de faire en sorte que le guide de structure active 7 et son extrémité conique 14 ne dépassent pas la zone active ZA. Dans ce cas, la zone passive ZP ne comporte qu'une seule partie non enterrée et l'interface, ou "butt joint", se trouve confondue avec la zone de guide planaire.

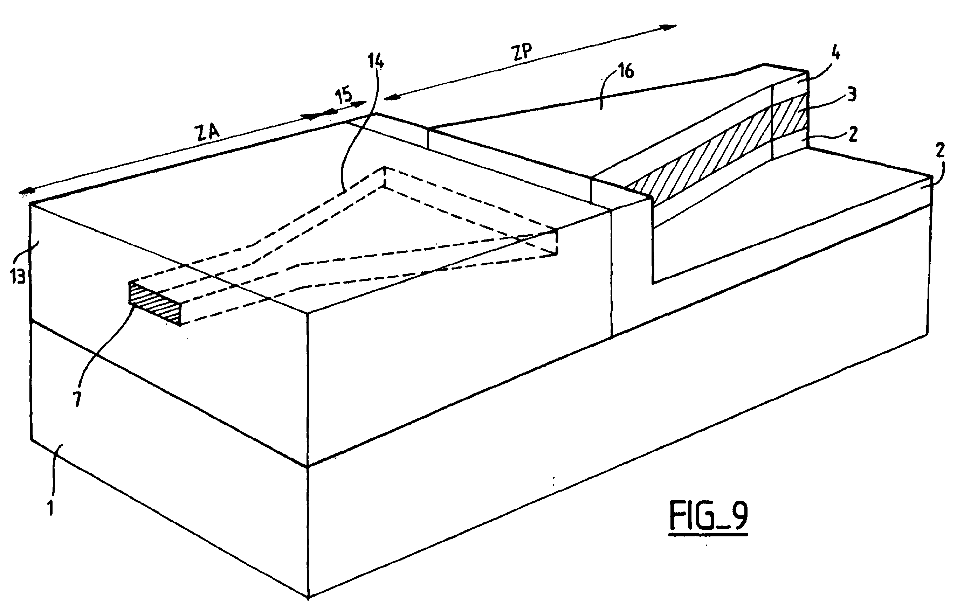

Cette variante de réalisation est illustrée sur la vue en perspective de la figure 9. Le guide actif 7 et son extrémité conique 14 sont réalisés dans la zone active ZA et sont enterrés dans une couche de gaine 13. Le guide passif 3 et son extrémité conique 16 sont réalisés dans la zone passive ZP et ne sont pas enterrés. L'interface, ou "butt joint", entre les deux zones active ZA et passive ZP est alors confondue avec la zone 15 non guidée latéralement.

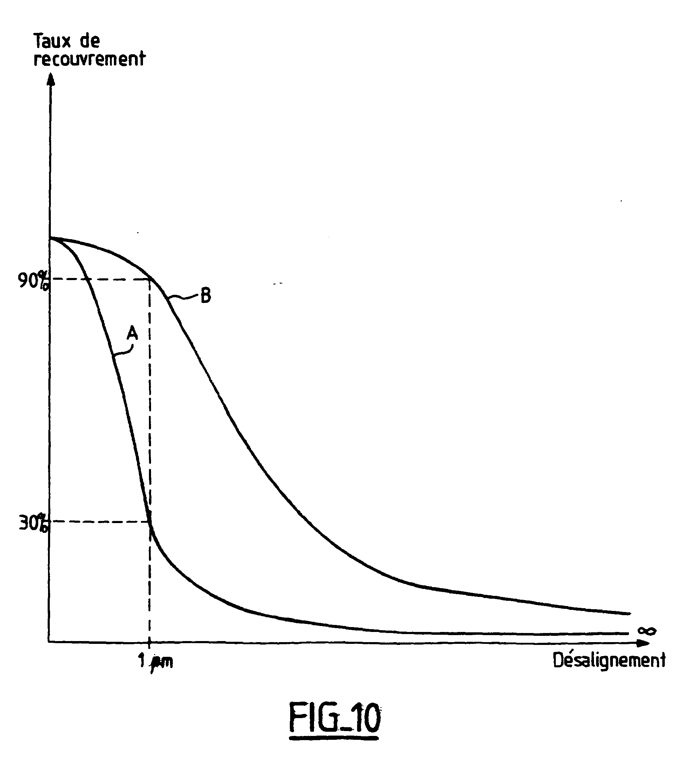

La figure 10 schématise des courbes A et B illustrant l'évolution du taux de recouvrement des modes optiques de deux guides d'onde de structures différentes en fonction de leur désalignement, respectivement pour des tailles de guides non élargies et pour des tailles de guides élargies jusqu'à 6µm.

Dans le cas de la courbe A, c'est à dire lorsque la taille des guides d'onde n'est pas élargie, un désalignement de 1µm entre les différents guides correspond à des pertes optiques de couplage de 5dB, c'est à dire à un taux de recouvrement des modes optiques seulement de 30%.

En revanche, lorsque la taille des guides est élargie à 6µm (courbe B) les pertes optiques de couplage, pour un désalignement de 1µm entre les différents guides, sont très amoindries et sont d'environ 0,5dB, ce qui correspond à un taux de recouvrement des modes optiques de 90%.

En conséquence, cet élargissement de la taille des guides d'onde permet de relâcher les tolérances d'alignement de ces guides.

## Revendications

1. Procédé de fabrication de circuits optiques intégrés comprenant au moins deux guides d'onde (7, 3) de structures différentes, deux portions d'extrémité appartenant respectivement auxdits guides (7, 3) étant couplées entre elles, ledit procédé comprenant les étapes suivantes :
• on réalise un premier desdits guides (7) par gravure, au moyen d'un premier masque (10),
• dans une étape ultérieure et distincte, on réalise l'autre guide (3), dit deuxième guide par gravure, au moyen d'un deuxième masque (12) distinct dudit premier masque (10),
ledit procédé étant **caractérisé en ce que** chacun desdits masques (10, 12) est tel que lesdites portions d'extrémité couplées sont élargies de manière à élargir la taille latérale de mode des ondes optiques sortant desdites portions d'extrémité.

2. Procédé selon la revendication 1 **caractérisé en ce que** lesdits masques (10, 12) ont des extrémités correspondant aux portions d'extrémité couplées desdits guides qui sont élargies.

3. Procédé selon l'une des revendications 1 ou 2, **caractérisé en ce que** lesdites portions d'extrémité sont élargies sous forme de cônes (14, 16) dont les génératrices sont rectilignes ou incurvées.

4. Circuit optique intégré comprenant au moins deux guides d'onde (7, 3) de structures différentes, deux portions d'extrémité appartenant respectivement auxdits guides (7, 3) étant couplées entre elles, **caractérisé en ce que** lesdites portions d'extrémité couplées sont séparées l'une de l'autre uniquement par une zone non guidée latéralement (15) et sont élargies de manière à élargir la taille latérale de mode des ondes optiques issues desdites portions d'extrémité.

5. Circuit optique intégré selon la revendication 4, **caractérisé en ce que** lesdites portions d'extrémité couplées se présentent sous la forme de cônes (14, 16) dont les génératrices sont rectilignes ou incurvées.

6. Circuit optique intégré selon l'une des revendications 4 ou 5 **caractérisé en ce qu'**il comprend une zone active (ZA), renfermant un guide d'onde de structure active (7) enterré dans une couche de gaine (13), et une zone passive (ZP) divisée en deux parties, une première partie (ZPE) étant enterrée dans la couche de gaine (13) et renfermant la (les) portion(s) d'extrémité couplée(s) de forme conique du guide de structure active, et une deuxième partie (ZPD) étant non enterrée et comportant un guide d'onde de structure passive (3) et sa (ses) portion(s) d'extrémité couplée(s) de forme conique (16).

7. Circuit optique intégré selon l'une des revendications 4 ou 5, **caractérisé en ce qu'**il comprend une zone active (ZA), renfermant un guide d'onde de structure active (7) et sa (ses) portion(s) d'extrémité couplée(s) de forme conique (14) enterrées dans une couche de gaine (13), et une zone passive (ZP) non enterrée comportant un guide d'onde de structure passive (3) et sa (ses) portion(s) d'extrémité couplée(s) de forme conique (16).

## Claims

1. A method of fabricating optical integrated circuits comprising at least two waveguides (7, 3) with different structures, respective end portions of said waveguides (7, 3) being coupled to each other, said method comprising the following steps:
· a first waveguide (7) is produced by etching using a first mask (10);
· in a later and separate step, the other or second waveguide (3) is produced by etching using a second mask (12) separate from said first mask (10);
· said method being **characterized in that** each of said masks (10, 12) is such that said coupled end portions are widened in order to widen laterally the modes of the optical waves leaving said end portions.

2. A method according to claim 1, **characterized in that** said masks (10, 12) have widened ends corresponding to the coupled end portions of said waveguides.

3. A method according to either of claims 1 or 2, **characterized in that** said end portions are widened in the form of cones (14, 16) having generator lines that are rectilinear or curved.

4. An optical integrated circuit comprising at least two waveguides (7, 3) with different structures, respective end portions of said waveguides (7, 3) being coupled to each other, **characterized in that** said coupled end portions are separated from each other only by a zone (15) with no lateral guidance and are widened in order to widen laterally the modes of the optical waves leaving said end portions.

5. An optical integrated circuit according to claim 4, **characterized in that** said coupled end portions (14, 16) take the form of cones having generator lines that are rectilinear or curved.

6. An optical integrated circuit according to either of claims 4 or 5, **characterized in that** it comprises an active zone (ZA) including an active structure waveguide (7) buried in a cladding layer (13) and a passive zone (ZP) divided into two portions, a first portion (ZPE) buried in the cladding layer (13) and including the conical coupled end portion or portions of the active structure waveguide and a second portion (ZPD) that is not buried and includes a passive structure waveguide (3) and its conical coupled end portion or portions (16).

7. An optical integrated circuit according to either of claims 4 or 5, **characterized in that** it comprises an active zone (ZA) including an active structure waveguide (7) and its conical coupled end portion or portions (14) buried in a cladding layer (13) and a passive zone (ZP) that is not buried and includes a passive structure waveguide (3) and its conical coupled end portion or portions (16).

## Patentansprüche

1. Verfahren zum Herstellen integrierter optischer Schaltungen, die wenigstens zwei Wellenleiter (7, 3) mit unterschiedlichen Strukturen umfassen, wobei zwei Endabschnitte, die zu dem einen bzw. zu dem anderen dieser Leiter (7, 3) gehören, miteinander gekoppelt sind, wobei das Verfahren die folgenden Schritte umfasst:
- Herstellen eines ersten Leiters (7) durch Ätzen mittels einer ersten Maske (10),
- in einem späteren und hiervon verschiedenen Schritt Herstellen des anderen so genannten zweiten Leiters (3) durch Ätzen mittels einer zweiten Maske (12), die von der ersten Maske (10) verschieden ist,
wobei das Verfahren **dadurch gekennzeichnet ist, dass** jede der Masken (10, 12) derart ist, dass die gekoppelten Endabschnitte verbreitert sind, derart, dass die seitliche Größe der Wellenform der Lichtwellen, die die Endabschnitte verlassen, verbreitert ist.

2. Verfahren nach Anspruch 1, **dadurch gekennzeichnet, dass** die Masken (10, 12) Enden besitzen, die den gekoppelten Endabschnitten der Leiter, die verbreitert sind, entsprechen.

3. Verfahren nach einem der Ansprüche 1 oder 2, **dadurch gekennzeichnet, dass** die Endabschnitte in Form von Kegeln (14, 16) erweitert sind, deren Erzeugende geradlinig oder gekrümmt sind.

4. Integrierte optische Schaltung mit wenigstens zwei Wellenleitern (7, 3) mit unterschiedlichen Strukturen, wobei zwei Endabschnitte, die zu dem einen bzw. zu dem anderen der Leiter (7, 3) gehören, miteinander gekoppelt sind, **dadurch gekennzeichnet, dass** die gekoppelten Endabschnitte voneinander nur durch eine seitlich nicht geführte Zone (15) getrennt sind und in der Weise erweitert sind, dass die seitliche Größe der Wellenform der Lichtwellen, die von den Endabschnitten ausgegeben werden, verbreitert ist.

5. Integrierte optische Schaltung nach Anspruch 4, **dadurch gekennzeichnet, dass** die gekoppelten Endabschnitte die Form von Kegeln (14, 16) aufweisen, deren Erzeugende geradlinig oder gekrümmt sind.

6. Integrierte optische Schaltung nach einem der Ansprüche 4 oder 5, **dadurch gekennzeichnet, dass** sie eine aktive Zone (ZA), die einen Wellenleiter (7) mit aktiver Struktur, der in einer Mantelschicht (13) vergraben ist, umschließt, und eine passive Zone (ZP), die in zwei Teile unterteilt ist, umfasst, wobei ein erster Teil (ZPE) in der Mantelschicht (13) vergraben ist und den (die) gekoppelten Endabschnitt(e) mit konischer Form des Leiters mit aktiver Struktur umschließt und ein zweiter Teil (ZPD) nicht vergraben ist und einen Wellenleiter (3) mit passiver Struktur und seine(n) gekoppelten Endabschnitt(e) (16) mit konischer Form aufweist.

7. Integrierte optische Schaltung nach einem der Ansprüche 4 oder 5, **dadurch gekennzeichnet, dass** sie eine aktive Zone (ZA), die einen Wellenleiter (7) mit aktiver Struktur und seine(n) gekoppelten Endabschnitt(e) (14) mit konischer Form, die in einer Mantelschicht (13) vergraben sind, umschließt, und eine nicht vergrabene passive Zone (ZP), die einen Wellenleiter (3) mit passiver Struktur und seine(n) gekoppelten Endabschnitt(e) (16) mit konischer Form aufweist, umfasst.
